Europäisches Patentamt

European Patent Office

Office européen des brevets

(11) Publication number: **0 474 333 A1**

# EUROPEAN PATENT APPLICATION

(21) Application number: **91305417.7**

(22) Date of filing: **14.06.91**

(51) Int. Cl.⁵: **G11B 5/72, G11B 5/84**

(30) Priority: **14.08.90 US 567072**

(43) Date of publication of application:
**11.03.92 Bulletin 92/11**

(84) Designated Contracting States:
**DE FR GB IT NL**

(71) Applicant: **SEAGATE TECHNOLOGY INTERNATIONAL**
**c/o Maples & Calder P.O. Box 309**
**Georgetown Grand Cayman Island(KY)**

(72) Inventor: **Miller, Mark S.**
**5820 Jeff Place**
**Edina, Minnesota 55436(US)**
Inventor: **Peterson, Roger L.**
**4141 Chicago Avenue**
**Minneapolis, Minnesota 55407(US)**

(74) Representative: **Miller, Joseph et al**
**J. MILLER & CO. Lincoln House 296-302 High Holborn**
**London WC1V 7JH(GB)**

(54) A process for manufacturing a magnetic recording medium.

(57) A process for manufacturing a magnetic recording medium, includes the steps of depositing a crystalline under layer (34) onto a substantially planar surface of a substrate (32), and depositing a crystalline recording layer (36) onto the crystalline under layer (34). The exposed surfaces of the magnetic recording layer are passivated in an oxygen atmosphere. Following passivation, there follows the step of sputter depositing directly onto the magnetic recording layer a protective cover layer (38) of partially stabilised zirconia and/or partially stabilised hafnia.

**FIG. 2**

This invention relates to processes for manufacturing magnetic recording media.

Magnetic recording involves magnetic disks typically housed within disk drives and rotated on an axis, with data transducing heads positioned in close proximity to the recording surfaces of the disks and moved generally radially with respect to the disks. Generally, the disks are of two kinds: flexible or "floppy" disks in contact with associated transducing heads at all times; and rigid disks. Rigid disks are rotated at much higher speeds than flexible disks. Consequently the transducing heads, during reading and recording operations, are maintained at a controlled distance from the disk recording surfaces, supported on a "bearing" of air as the disks rotate. Such transducing heads contact their associated rigid disks only when the disks are stationary, when they accelerate from a stop, and when they decelerate just before coming to a complete stop.

As compared to flexible disks, rigid disks and disk drives are subject to stricter design tolerances, arising from the greater density of data stored on disk recording surfaces. It is considered desirable during reading and recording operations to maintain each transducing head as close to its associated recording surface as possible, i.e. to minimise the "flying" height of the head. A reduction in flying height improves signal to noise ratio, enhancing the speed and accuracy of reading and recording operations, and increasing the density at which data can be stored.

The utility of protective cover layers in magnetic recording media is well known. Materials employed as magnetic thin films, typically magnetic alloys such as cobalt-nickel, cobalt-chromium-tantalum, cobalt-chromium-platinum, cobalt-nickel-platinum, cobalt-nickel-chromium and cobalt-chromium among others, are susceptible to corrosion, particularly in relatively humid environments. Moisture in the air reacts with exposed surface areas of the media, degrading or destroying the capability of the material to be magnetised at corrosion sites. This diminishes the capacity of the magnetic medium to store data, and gives rise to the desire to protect the magnetic thin film against exposure to moisture. While corrosion protection of the magnetic alloy is required of the over coat, the tribological or wear properties of the over coat are of primary concern. Even in the case of rigid disks, there is a substantial amount of surface contact between the disks and transducing heads. The over coat must maintain its surface integrity and inter-act with the transducing head in a manner to minimise wear or damage to the transducing head.

In connection with rigid disk media, the traditional approach to meeting this need is to apply a film or over coat of hard, amorphous carbon. Carbon coatings, however, tend to develop pin holes that expose the magnetic recording film to corrosion. Particulates formed at corrosion sites can interfere with the reading and writing of data, and can eventually cause a transducing head to crash. Corrosion sites frequently are slightly raised, and cause aerodynamic instability in the air bearing which supports the transducing head relative to its associated recording surface. Resulting fluctuations in the head can lead to a head crash, particularly at low flying heights. Carbon films also are susceptible to local microscopic heating due to head contact friction. Locally intense heat converts carbon from the SP-3 phase to the SP-2 phase, a transformation that can lead to sublimation of the carbon over coat, and subsequently increased wear.

Recent designs for rigid disk drives also contemplate disk rotation at speeds of up to 5,000 revolutions per minute as compared to the 1,800 rpm in conventional drives. The result is a need for improved tribological qualities in the protective over coat, due to the higher speeds themselves, and also due to the fact that higher disk rotational speeds result in the transducing head contacting the disk, particularly the over coat, for longer periods of time. Carbon over-coats wear rapidly at speeds approaching 5,000 rpm, due to such increased contact with the travelling head during acceleration and deceleration of the disk. Such wear eventually can expose the underlying magnetic layer.

Frequently, liquid lubricants have been applied to improve tribological characteristics of carbon and silicon coatings, and do improve both friction and wear characteristics. Lubricant layers are increasingly subject to wear or spin off at higher rotational speeds, eventually exposing the carbon layer beneath the lubricant. Chromium under layers have been applied immediately beneath carbon coatings in an attempt to resist corrosion of the carbon layers. Whilst this technique has successfully increased resistance to corrosion, the combined layer thickness reduces signal amplitude to a head.

In view of the deficiencies in carbon over-coats, alternative cover layer materials have been explored. For example, EP-A-0,240,088 discloses a variety of protective coatings based on zirconium, including zirconium oxide (zirconia), zirconium boride, zirconium carbide and zirconium nitride. The coatings are deposited by sputtering, and preferably include a stabiliser such as yttrium oxide ($Y_2O_3$), calcium oxide or magnesium oxide. EP-A-0,240,088 teaches that an intermediate layer enhances control of the reliability of the magnetic disk, stating that a zirconia film formed directly onto magnetic media may blister and peel due to stress at the bond between the cover layer and medium, caused by friction from contact with the transducing head. This failure was reported as observed after just one hundred CSS (contact start stop) test cycles. An intermediate layer of chromium, zirconium, hafnium, titanium, tantalum or tungsten, or an alloy of these materials, is said to reduce this problem. Of course, it also adds to the thickness of the material covering the magnetic thin film recording medium.

The present invention seeks to provide: a magnetic recording medium in which a zirconia or hafnia based cover layer is applied directly to a magnetic thin film recording layer, with minimal degradation of the cover layer tribology, even after thousands of CSS cycles; a process for manufacturing a magnetic recording medium, in which a protective over layer is applied directly to a magnetic thin film layer in a reactive sputtering process favourable to forming zirconia or hafnia upon the thin film, thus to enhance the quality of the over coat; and a method of treating a magnetic thin film recording layer of a recording medium, just prior to forming a protective cover layer onto the magnetic film, to enhance adhesion of the cover layer to the film for improved performance and longer life of the resulting recording medium.

According to one aspect of the present invention there is provided a process for manufacturing a magnetic recording medium, including the steps of: depositing a crystalline under layer onto a substantially planar surface of a substrate; and depositing a crystalline recording layer onto the crystalline under layer; characterised by passivating the exposed surfaces of the magnetic recording layer in an oxygen atmosphere; and following passivation sputter depositing directly onto the magnetic recording layer a protective cover layer of partially stabilised zirconia and/or partially stabilised hafnia.

Preferably, following passivation, the method provides the steps of enclosing the substrate, under layer and a target of partially stabilised zirconia and/or partially stabilised hafnia within a vacuum deposition chamber in a substantially inert gas atmosphere at a pressure in the range of from about 0.13 Pa to about 1.3 Pa (about 1 millitorr to about 10 millitorr) to sputter deposit the protective cover layer onto the magnetic recording layer to a thickness within the range of from 0.025 micron to 0.035 micron (about 250 Å to about 350 Å).

The protective cover layer may consist of from 85% to 98% by weight of either hafnia or zirconia, and from 2% to 15% by weight of a stabiliser, said stabiliser consisting essentially of a rare earth oxide. Said stabiliser may be one or more of yytrium oxide ($Y_2O_3$), calcium oxide (CaO), or magnesium oxide (MgO).

Preferably the step of sputter depositing the protective cover layer includes RF reactive sputtering in an atmosphere of an inert gas and oxygen. In one embodiment the partial pressure of inert gas is below 2 Pa (15 millitorr) and the partial pressure of oxygen is at most 0.02 Pa (0.15 millitorr).

Said substrate may be pre-heated to a temperature in the range of from 120°C to 230°C prior to depositing the crystalline under layer.

The process may include pre-heating the substrate, under layer and recording layer to a temperature in the range of from 120°C to 230°C just prior to sputter depositing said protective cover layer.

Said passivation step may include maintaining the recording layer in an oxygen atmosphere for a time period of from one to five minutes.

According to another aspect of the present invention there is provided a process for forming a protective cover layer over a magnetic recording medium, characterised by including the steps of: enclosing a magnetic recording medium, including at least a substrate and a magnetic thin film recording layer deposited on the substrate, along with a target consisting of a cover layer material, within a vacuum deposition chamber in an inert gas atmosphere at a pressure in the range of from 0.13 Pa to 1.3 Pa (1 millitorr to 10 millitorr), said atmosphere further including oxygen at a partial pressure of at most 0.02 Pa (0.15 millitorr), to deposit a protective cover layer of said cover layer material by RF reactive sputtering onto said magnetic thin film recording layer, to a thickness within the range of from about 0.025 micron to about 0.03 micron (about 250 Å to about 350 Å), said cover layer material consisting essentially of one or both of the following constituents: partially stabilised zirconia and partially stabilised hafnia.

According to a further aspect of the present invention there is provided a process for manufacturing a magnetic recording medium, including the following steps: depositing a crystalline under layer onto a substantially planar surface of a substrate; depositing a crystalline recording layer comprised of magnetic recording material onto the crystalline under layer; passivating the magnetic recording layer interface in an oxygen atmosphere; and following passivation, enclosing the substrate, under layer and magnetic recording layer, along with a target formed of a cover layer material, within a vacuum deposition chamber in a substantially inert gas atmosphere at a pressure in the range of from about 0.13 Pa to about 1.3 Pa (about 1 millitorr to about 10 millitorr) and sputter depositing a cover layer onto the magnetic recording layer, to a thickness within the range of from about 0.025 micron to 0.035 micron (about 250 Å to about 350 Å) and preferably about 0.03 micron (about 300 Å) with the cover layer consisting essentially of one or both of the following constituents: partially stabilised zirconia, and partially stabilised hafnia.

The preferred manner of applying the protective cover layer is by RF reactive sputtering, in an atmosphere of gases such as argon and oxygen. A negative RF bias is applied to the stabilised hafnia or zirconia target, which causes positively charged argon atoms to be accelerated towards the target. The accelerated ions and neutral particles sputter the stabilised hafnia or zirconia onto a substrate placed near the target. Typical stoichiometry of the sputtered over coat is from 2 to 15% by weight stabiliser and from 85 to 98% by weight hafnia or zirconia.

RF magnetron, ion beam or reactive sputtering from a metallic zirconium, hafnium, stabilised zirconia or hafnia target may be employed to deposit the over-coat. Typical oxygen partial pressures will range from 4 x $10^{-3}$ Pa to 0.13 Pa (0.03 millitorr to 1.0 millitorr) although preferably at most 0.013 Pa (0.10 millitorr) depending on the technique and apparatus employed and more preferably approximately 1.1 x $10^{-2}$ Pa (0.08 millitorr). Oxygen pressures that are too high reduce over coat density, thereby degrading tribological results. Argon pressures of 1.3 Pa (10 millitorr) or less are also employed, to minimise the amount of void content present in the sputtered film. Highly voided hafnia or zirconia over-coats have been found to demonstrate poor tribological properties, leading to head crashes.

The process may also include the application of a negative bias in the range of from 50 to 250 volts to the substrate. Biasing of the substrate reduces grain size and improves film packing density, for a better wearing cover layer.

In the passivation step, the substrate, under layer and recording layer are maintained in an oxygen atmosphere at a pressure in the range of from about -6.65 x $10^{-3}$ Pa to about 0.13 Pa (about 5 x $10^{-2}$ millitorr to about 1 millitorr) with the preferred oxygen pressure being about 0.013 Pa to about 0.04 Pa (about 0.1 to 0.3 millitorr). However, the partial pressure of oxygen could be as low as 5.3 x $10^{-3}$ Pa (0.04 millitorr). The time of passivation is approximately one to five minutes, with a preferred time being about two minutes, although this may vary based on the nature of the vacuum deposition chamber, the magnetic thin film layer material, and the protective over coat material to be applied.

The preferred thickness of the protective layer, whether partially stabilised zirconia or hafnia is about 0.03 micron (about 300 Å). No intermediate adhesion enhancing layer is required between the thin film and cover layer. Consequently, the separation of the transducing head from the thin film layer during reading and recording operations is reduced, without reducing the flying height, for improved performance and data storage density in the recording medium. Tribological properties remain excellent after thousands of CSS cycles, with both static and kinetic (dynamic) friction co-efficients remaining below 1, and with the application of a fluorocarbon lubricant reducing these co-efficients to below 0.5.

The invention is illustrated, merely by way of example, in the accompanying drawings, in which:-

Figure 1 is a plan view of a rotatable rigid magnetic recording disk manufactured in accordance with a process according to the present invention and a transducing head supported generally for movement radially of the disk;

Figure 2 is an enlarged partial sectional view of the magnetic disk of Figure 1;

Figure 3 is a schematic view of a vacuum deposition apparatus utilised in forming the magnetic disk of Figure 1;

Figure 4 is a chart illustrating the change in 1 rpm co-efficient of friction, over a range of CSS test cycles for a recording medium including a partially stabilised hafnia over layer formed in accordance with a process according to the present invention; and

Figure 5 is a chart illustrating comparative co-efficients of friction over a range of CSS cycles, for lubricated and unlubricated partially stabilised zirconia cover layers applied directly over a chromium under layer.

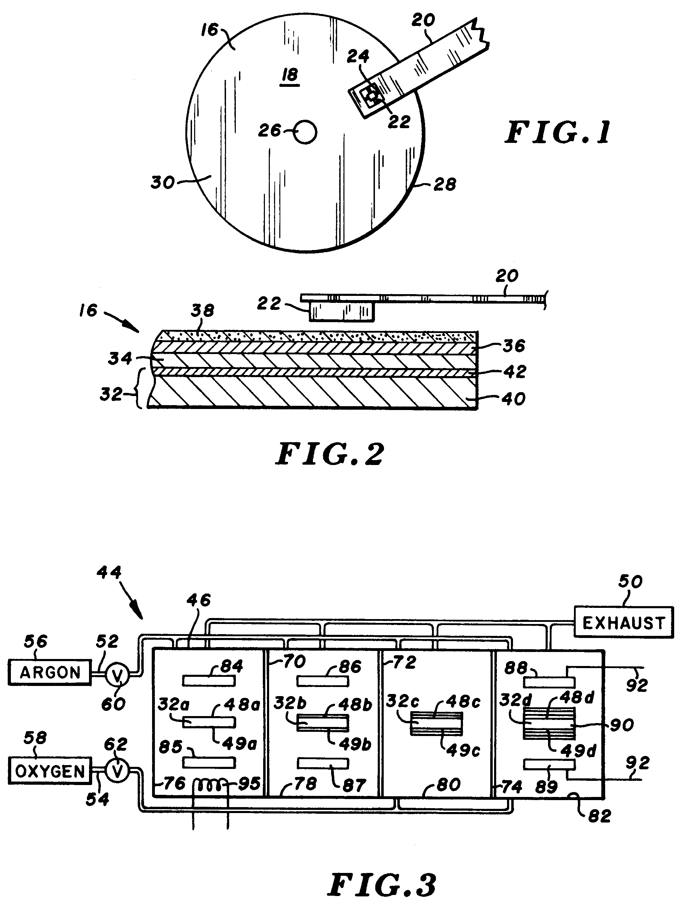

Referring first to Figures 1 and 2, a rigid magnetic recording disk 16 is rotatable about a vertical axis and has a substantially planar and horizontal upper surface 18. A transducing head support arm 20 is part of a carriage assembly supported for linear reciprocation radially of the disk 16. A magnetic transducing slider or head 22 is supported by the arm 20 through a head suspension 24, for movement relative to the magnetic disk along with the arm. The suspension 24 allows for gimballing action of the head, i.e. limited vertical travel and limited rotation about pitch and roll axes.

At the centre of the magnetic disk 16 is an opening 26 to accommodate a vertical spindle of a disk drive (not shown) used to rotate the magnetic disk about the vertical axis. Between the opening 26 and an outer circumferential edge 28 of the disk, a plurality of a circular tracks of data, and perhaps servo information, are provided in a data storage region or area 30.

As seen from Figure 2, the magnetic disk 16 is formed of a plurality of layers on a substrate 32. These layers comprise an under layer 34, a magnetic thin film recording layer 36, and a protective cover layer 38 over the recording layer. More particularly, the disk 16 is formed first by polishing, grinding or otherwise machining an aluminium substrate disk 40 to provide a substantially flat upper surface of the substrate. Next, a nickel-phosphorous (NiP) alloy layer 42 is plated onto the upper surface of the substrate disk, to provide a substantially uniform layer having a thickness of preferably about 10 microns, and within a range of from 5 to 20 microns. Following plating, the alloy layer 42 is polished to a roughness of generally less than 0.00254 micron (0.1 micro-inch) for example by a silicon carbide grit lapping process. This normally is accomplished with a cloth or paper carrying the grit, and also can involve a liquid slurry containing grit in combination with a cloth or paper if desired. Such processes are known and not further discussed here.

Following polishing, the remaining layers illustrated in Figure 2 are applied, preferably by vacuum sputter deposition. An example of an apparatus suitable for deposition is schematically illustrated at 44 in Figure 3. The apparatus includes a fluid type sputtering or plasma chamber 46 in which a plurality of substrates 32a to 32d are enclosed, with respective upward and downward facing surfaces 48a to 48d and 49a to 49d. The apparatus further includes an exhaust pump 50 in fluid communication with the chamber 46 for evacuating the chamber when desired. Also in fluid communication with the chamber, through lines 52, 54, respectively, are a container 56 for supplying an inert gas such as argon, and a container 58 for supplying oxygen to the chamber. Each of a pair of valves 60, 62 controls the supply of its associated gas to the plasma chamber 46.

Partitions 70, 72, 74 divide the plasma chamber 46 into four separate sub-chambers indicated at 76, 78, 80, 82. In the sub-chambers 76, chromium targets 84, 85 are electrically connected as cathodes and positioned in spaced apart relation to the substrate 32a, facing the surfaces 48a, 49a of the substrate, respectively. In the sub-chamber 78, targets 86, 87 of an appropriate magnetic alloy, e.g. cobalt-chromium-tantalum, are positioned spaced apart from and facing the chromium layers covering the surfaces 48a, 49b of the substrate 32b. The sub-chamber 82 contains a pair of targets 88, 89 formed of an over coat material, preferably either partially stabilised zirconia or partially stabilised hafnia. Preferably, each of the targets/cathodes is parallel to the surface 48 or 49 of its corresponding substrate. A means 95 is provided in the sub-chamber 76 for pre-heating the substrate 32a.

Thus, the plasma chamber 46 is used to apply the under layer 34, the recording layer 36 and the protective cover layer 38 to each of the substrates. This permits application of the chromium under layer and the magnetic aloy layer without any intervening exposure to reactive gases, thereby preventing oxidation of the under layer and the magnetic alloy. The partitions prevent cross contamination, to enable application of all necessary layers in a single chamber.

In order to apply the under layer 34 to the substrate 32, the exhaust pump 50 is actuated to evacuate the plasma chamber 46 substantially completely. Following evacuation, the valve 60 is opened to supply argon to the sub-chamber 76, until the pressure within the sub-chamber reaches a pre-determined value, for example from $1.33 \times 10^{-3}$ to $1.33 \times 10^{-1}$ Pa ($10^{-5}$ to $10^{-3}$ torr), or preferably $6.66 \times 10^{-2}$ Pa ($5 \times 10^{-4}$ torr) for DC magnetron sputtering. The substrate is preferably pre-heated to a temperature in the range of from 100 to 230°C, but most preferably 200°C. Pre-heating of the substrate in the range of 120 to 250°C improves the crystallographic orientation and density of the various layers. Power at a desired level, for example 5 watts per square centimetre, is supplied to the targets 84, 85 to generate an electrical field and ionise the argon, forming an argon plasma within the chamber. The electrical field accelerates the argon ions onto the chromium targets 84, 85, until a sufficient number of chromium atoms have sputtered onto the substrate 32a to form the chromium under layer to its desired thickness. The under layer is formed with a substantially uniform thickness preferably of about 0.2 micron (2,000 Å) within a range of from 0.02 to 0.3 micron (200 to 3,000 Å).

The under layer 34 is crystalline in nature and pre-determines the orientation of the subsequently applied crystalline magnetic thin film. In particular, the crystallographic orientation of the chromium layer is substantially uniform, and controls the orientation of the magnetic alloy crystals epitaxially grown upon the under layer such that axes of easy magnetisation of the crystals comprising the thin film recording layer are substantially aligned in a plane parallel to the substrate surface, a feature desired in magnetic thin film recording.

Following deposition of the under layer 34, the substrate and the under layer are transferred from the sub-chamber 76 to the sub-chamber 78. Argon pressure is held at the same level as in the sub-chamber 76, or adjusted as appropriate if the recording layer 36 is to be sputtered at a different argon pressure than the under layer 34. The targets 86, 87 are biased to generate the required electric field once again. In the sub-chamber 78, argon ions are accelerated by the electrical field onto the targets 86, 87. The accelerated argon ions, and neutral argon atoms, sputter the target material onto the under layer 34. Vacuum deposition, again preferably DC magnetron sputtering, proceeds until the magnetic thin film recording layer has been applied to a preferred thickness of 0.07 micron (700 Å), or a thickness in the range of 0.025 to 0.1 micron (250 to 1,000 Å). Along with previously mentioned cobalt chromium tantalum, other materials suitable for the magnetic thin film include cobalt chromium, cobalt platinum chromium, cobalt nickel, cobalt nickel platinum, cobalt phosphorous, cobalt nickel phosphorous and cobalt nickel chromium.

Following deposition of the recording layer 36, the substrate, the under layer and the recording film are placed within the chamber 80 for passivation of the exposed surfaces of the magnetic layers in an oxygen atmosphere. In preparation for this step, the sub-chamber 80 is evacuated by the exhaust pump 50, after which the valve 62 is opened to admit oxygen into the chamber to a pressure in the range of from 6.67 x $10^{-3}$ to 1.3 x $10^{-1}$ Pa (0.05 to 1.0 millitorr), preferably in the range of about 1.3 x $10^{-2}$ Pa to about 4 x $10^{-2}$ Pa (about 0.1 to about 0.3 millitorr), and more preferably about 1.3 x $10^{-2}$ Pa (0.1 millitorr). The required time for passivation is relatively brief, preferably about one minute or within the range from 0.5 to five minutes. Passivation enhances adhesion of the protective cover layer 38 to the recording layer 36, for improved wear and friction properties to the disk 16 without an intermediate adhesion layer between the protective cover layer and the recording layer.

Following passivation, the substrate is transferred to the sub-chamber 82 for deposition of the protective cover layer 38. In preparation for this step, the exhaust pump 50 is used to evacuate the subchamber 82, then the valves 60, 62 are opened to provide a mixture of argon and oxygen, although primarily argon. More particularly, argon is provided to a pressure in the range of from 0.5 to 1.5 Pa (about 3.5 to 10 millitorr), while the partial pressure oxygen is preferably at most 0.02 Pa (0.15 millitorr), but within the range of about 0.01 to 0.04 Pa (0.08 to 0.3 millitorr). The partial pressure of argon is preferably at least an order of magnitude greater than the partial pressure of oxygen.

As previously mentioned, the preferred materials for the target 88 include partially stabilised zirconia and partially stabilised hafnia. A particularly preferred target structure for the targets 88, 89 includes either zirconium oxide or hafnium oxide at 90% by weight, with the balance as stabiliser. A permitted range for the hafnia or zirconia is 85 to 98% by weight along with a 2% to 15% by weight range for the stabiliser, which is preferably yttrium oxide ($Y_2O_3$), calcium oxide (CaO) or magnesium oxide (MgO).

Preferably, sputtering is by an RF reactive process, either RF diode sputtering or RF magnetron sputtering. The partial pressure of oxygen counter-acts the tendency of the sputtered hafnia or zirconia molecules to break down into their metallic and oxygen components, and maintains the oxygen stoichimetry in the sputtered thin film layer.

During RF reactive sputtering, a negative RF bias of 250 to 1,000 volts is applied to the targets 88, 89 via a line 92, and a negative RF bias of 50 to 200 volts may be applied to the substrates through a line 90. Preferably, the RF power is in the range from 200 to 1000 watts. The bias applied to the substrate reduces grain size and contamination, and thus improves the wear capabilities of the cover layer. Application of the negative bias to the target 88 tends to accelerate positive ions moving towards the target, thereby sputtering the partially stabilised zirconia or hafnia from the target. The RF reactive sputtering continues until the cover layer 38 has a substantially uniform thickness within the range of 0.025 to 0.035 micron (250 to 350 Å), and more preferably about 0.03 micron (300 Å).

If desired, oxygen passivation and application of the protective cover layer 38 can be accomplished in the same chamber, so long as oxygen is evacuated to a sufficiently low partial pressure. The magnetic thin film recording layer should be applied in a separate chamber, however, as even slight oxygen contamination could substantially degrade the magnetic recording layer.

At this point the substrate 32, with the under layer 34, the recording layer 36 and the protective cover layer 38 applied, is removed from the plasma chamber 46. If desired, a liquid lubricant can be applied to the disk in a known manner, e.g. by spin application. One of the features of the present invention, however, is that such liquid lubricant is not necessarily required.

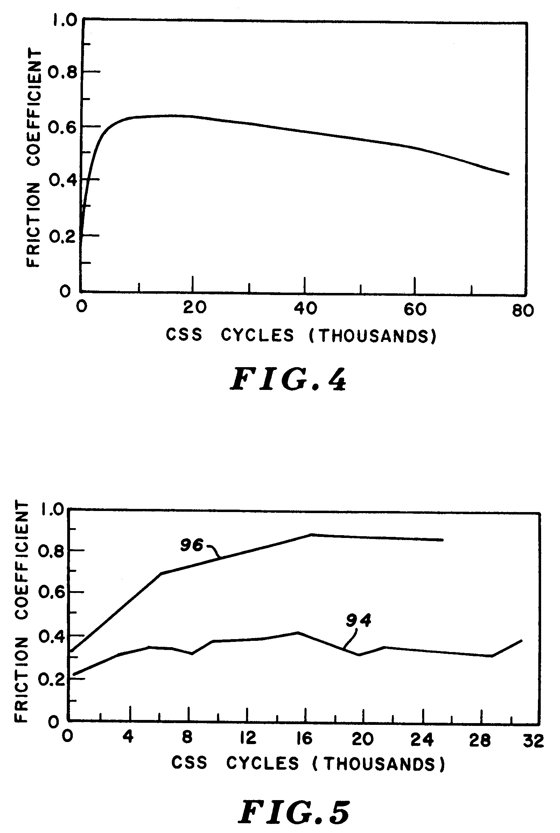

The coating adheres to the recording layer 36, and produces a long wearing surface having favourable static and kinetic friction co-efficients. The chart of Figure 4 relates to test results from sample media coated with partially stabilised hafnia. The hafnia was applied to a thickness of 0.035 micron (300 Å), applied at about 0.53 Pa (4 millitorr) argon pressure, 2 x $10^{-2}$ Pa (1.5 x $10^{-4}$ torr) oxygen pressure and at a bias of 4 watts per square centimetre. No liquid lubricant was applied to the sample media. The average co-efficient of 1 rpm friction reached a peak of about 0.65 after 20,000 CSS cycles, then exhibited a gradual decrease to approximately 0.5 after about 76,000 CSS cycles. Friction coefficients were found, based on a load of 9.5 grams applied to an aluminium oxide titanium carbide composite slider in contact with the disks. Thus, extremely favourable friction and wear characteristics were achieved. Maximum (as opposed to average) values for the co-efficient remained below 1.0.

The favourable friction co-efficients shown in the chart in Figure 4 are achieved in the absence of any lubricant. As seen from Figure 5, application of a fluorocarbon liquid lubricant to a partially stabilised zirconia protective cover layer further reduces the co-efficient of friction.

In accordance with the present invention, improved recording media employing partially stabilised zirconia or partially stabilised hafnia protective cover layers, exhibit excellent friction and wear characteristics as well as providing the required corrosion protection for the recording layer. Deposition of the protective cover layer at relatively low argon pressures, provision of a controlled oxygen background pressure during deposition, and oxygen passivation just prior to depositing the protective cover layer, all contribute to substantially improved media performance. This is readily apparent from tests performed on exemplary samples which demonstrate the enhanced mechanical properties of protective cover layers applied in accordance with the present invention.

In particular, yttria ($Y_2O_3$) stabilised zirconia ($ZiO_2$) was RF diode sputtered over a 0.2 to 0.3 micron (2,000 to 3,000 Å) thick chromium under layer, which had been previously applied to an aluminium/nickel/phosphorous substrate as previously described. In all cases the sputtering target included about ten atomic percent of the yttria stabiliser. The protective cover layer was sputtered to a thickness in the range of 0.03 to 0.035 micron (300 to 350 Å). The RF diode target input power, for applying the chromium under layer as well as the protective cover layer, was 3.6 watts per square centimetre. Substrate temperature was maintained at 120°C. The test samples were prepared without magnetic recording layers.

Other conditions were selectively varied, including the argon pressure during sputtering, the oxygen pressure, and the use of oxygen to passivate the chromium under layer just prior to zirconia deposition. These differences are illustrated in the following examples, each of which is based on the testing of from two to four samples.

Example I: The argon pressure was 0.5 Pa (3.8 millitorr), the background pressure of oxygen was 0.04 Pa (0.3 millitorr), and a bias was applied to the target but not to the substrate during sputtering.

Example II: Argon pressure was 0.5 Pa, the oxygen pressure was 0.02 Pa (0.15 millitorr), and a bias was applied only to the target.

Example III: The argon pressure was 0.5 Pa, the oxygen pressure was 0.01 Pa (0.75 millitorr), and a bias was applied only to the target.

Example IV: The argon pressure was 0.5 Pa and sputtering occurred in the absence of oxygen, with bias applied only to the target.

Example V: The argon pressure was 2.0 Pa, (15 millitorr), the pressure of oxygen was 0.01 Pa, and a bias was applied only to the target.

Example VI: The argon pressure was 2.0 Pa, the oxygen pressure was 0.04 Pa, and a bias was applied to the target and to the substrate.

Example VII: The argon pressure was 2.0 Pa, the oxygen pressure was 0.02 Pa, and a bias was applied to the target and substrate.

The test samples were subjected to friction measurement using strain gauges mounted on a transducing head slider supporting arm, with the slider being a composite of alumina and titanium carbide. Throughout CSS testing, friction measurements were taken at one revolution per minute. The acceleration time to 3,600 rpm was four seconds, and time for deceleration to stop was eight seconds. The slider flying height was approximately 250 nm.

The partially stabilised zirconia protective cover layers were analysed for film porosity and grain size distribution, using a TEM (transverse electron microscope), with the TEM voltage at 100 kilovolts. The results, by example, as shown in the following table:-

EP 0 474 333 A1

| EXAMPLE | PARTIAL PRESSURE Ar O2 (Pascal) | | BIAS | AVERAGE FRICTION COEFFICIENT (After 30,000 cycles) | GRAIN SIZE (nm) | VOID CONTENT |
|---------|-----|------|----------------------|----------------------|---------|---------|
| I | 0.5 | 0.04 | Target Only | 0.84 | 20-35 | 2% |
| II | 0.5 | 0.02 | Target Only | 0.85 | 20-35 | 2% |
| III | 0.5 | 0.01 | Target Only | 0.48 | 20-40 | 2% |
| IV | 0.5 | 0 | Target Only | 0.53 | 20-45 | 3% |
| V | 2.0 | 0.01 | Target Only | * | 10-45 | 10-20% |
| VI | 2.0 | 0.04 | Target and Substrate | * | 10-40 | 10-20% |
| VII | 2.0 | 0.02 | Target and Substrate | * | 10-40 | 10-20% |

**\*-Crashed during testing.**

Oxygen passivation proved to be an important step, as disks not subjected to oxygen passivation usually crashed during CSS testing. Apart from the table above, a general result of the testing was that superior wear results were obtained when the freshly deposited chromium under layer was briefly passivated in an oxygen atmosphere, at a pressure of 0.04 Pa, just prior to deposition of the protective cover layer. From the table, it is apparent that increased argon pressure during sputtering of the protective cover layer degrades the tribological qualities of the protective cover layer, in that the void content increases. Higher void content in the protective cover layer reduces film density and micro-hardness. Higher argon pressures also were found to increase the tensile stress in the protective cover layer. While a slight oxygen pressure during deposition of the protective cover layer (particularly 0.01 Pa) improved surface qualities, too high an oxygen partial pressure degraded performance, and was observed to cause small 3 x $10^{-3}$ micron (30 Å) voids in the protective cover layer, these voids reducing density of the protective cover layer.

Yet another result observed from this testing is that a substantial reduction in friction is achieved by applying a fluorocarbon lubricant to the partially stabilised zirconia protective cover layer. The results in the table above reflect the absence of a lubricant. In Figure 6, however, lubricated and unlubricated sample results are indicated at 94, 96, respectively. The results are shown for samples in which the protective cover layers were deposited at an argon pressure of 0.5 Pa, and an oxygen pressure of 0.02 Pa. The lubricant employed in the test is available from Montedison, and is identified as AM-2001. The unlubricated samples exhibit an average co-efficient of friction below 0.9, stabilising at just below 0.9 at about 16,000 CSS cycles. The lubricated surfaces show substantially improved average co-efficients, remaining well below 0.5, even above 30,000 cycles. It was further observed that the deviation in specific co-efficients from the average values was substantially reduced in the case of lubricated samples.

Thus, in accordance with the present invention, proper control of the argon or other inert gas pressure during a reactive protective cover layer deposition process, control of oxygen background pressure during such deposition, and a brief passivation of the magnetic thin film layer just prior to deposition of the protective cover layer, improve the wear and friction characteristics of the protective cover layer composed of partially stabilised zirconia or hafnia. Furthermore, with the improved adhesion achieved due to oxygen passivation, no intermediate layer need be deposited onto the recording layer prior to deposition of the protective cover layer, reducing the cost of manufacturing the recording media, as well as permitting closer transducing head proximity to the recording layer for a given flying height.

## Claims

1. A process for manufacturing a magnetic recording medium, including the steps of: depositing a crystalline under layer (34) onto a substantially planar surface of a substrate (32); and depositing a

8

crystalline recording layer (36) onto the crystalline under layer (34); characterised by passivating the exposed surfaces of the magnetic recording layer in an oxygen atmosphere; and following passivation sputter depositing directly onto the magnetic recording layer a protective cover layer (38) of partially stabilised zirconia and/or partially stabilised hafnia.

2. A process as claimed in claim 1 characterised by, following passivation, enclosing the substrate (32), under layer (34) and a target (88, 89) of partially stabilised zirconia and/or partially stabilised hafnia within a vacuum deposition chamber (82) in a substantially inert gas atmosphere at a pressure in the range of from about 0.13 Pa to about 1.3 Pa (about 1 millitorr to about 10 millitorr) to sputter deposit the protective cover layer (38) onto the magnetic recording layer (36) to a thickness within the range of from 0.025 micron to 0.035 micron (about 250 Å to about 350 Å).

3. A process as claimed in claim 1 or 2 characterised in that the protective cover layer (38) consists of from 85% to 98% by weight of either hafnia or zirconia, and from 2% to 15% by weight of a stabiliser, said stabiliser consisting essentially of a rarr earth oxide.

4. A process as claimed in claim 3 characterised in that the said stabiliser is one or more of yytrium oxide ($Y_2O_3$), calcium oxide (CaO), or magnesium oxide (MgO).

5. A process as claimed in any preceding claim characterised in that the step of sputter depositing the protective cover layer (38) includes RF reactive sputtering in an atmosphere of an inert gas and oxygen.

6. A process as claimed in claim 5 characterised in that the partial pressure of inert gas is below 2 Pa (15 millitorr) and the partial pressure of oxygen is at most 0.02 Pa (0.15 millitorr).

7. A process as claimed in any preceding claim characterised in that said substrate (32) is pre-heated to a temperature in the range of from 120°C to 230°C prior to depositing the crystalline under layer (34).

8. A process as claimed in any preceding claim characterised by including pre-heating the substrate (32), under layer (34) and recording layer (36) to a temperature in the range of from 120°C to 230°C just prior to sputter depositing said protective cover layer (38).

9. A process as claimed in any preceding claim characterised in that said passivation step includes maintaining the recording layer in an oxygen atmosphere for a time period of from one to five minutes.

10. A process for forming a protective cover layer over a magnetic recording medium, characterised by including the steps of: enclosing a magnetic recording medium, including at least a substrate (32) and a magnetic thin film recording layer (36) deposited on the substrate, along with a target (88, 89) consisting of a cover layer material, within a vacuum deposition chamber in an inert gas atmosphere at a pressure in the range of from 0.13 Pa to 1.3 Pa (1 millitorr to 10 millitorr), said atmosphere further including oxygen at a partial pressure of at most 0.02 Pa (0.15 millitorr), to deposit a protective cover layer (38) of said cover layer material by RF reactive sputtering onto said magnetic thin film recording layer (36), to a thickness within the range of from about 0.025 micron to about 0.03 micron (about 250 Å to about 350 Å), said cover layer material consisting essentially of one or both of the following constituents: partially stabilised zirconia and partially stabilised hafnia.

*FIG.1*

*FIG.2*

*FIG.3*

**FIG.4**

**FIG.5**

11

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A, D | EP-A-0 240 088 (KOMAG, INC) 7 October 1987<br>* page 4, line 24 - line 29 *<br>* page 6, line 20 - page 7, line 13 *<br>* claims 1-3,6 *<br>--- | 1-6 | G11B5/72<br>G11B5/84 |
| A | IEEE TRANSACTIONS ON MAGNETICS.<br>vol. 24, no. 6, November 1988, NEW YORK US<br>pages 2629 - 2634;<br>T.YAMASHITA ET AL.: 'SPUTTERED ZrO2 OVERCOAT<br>WITH SUPERIOR CORROSION PROTECTION AND<br>MECHANICAL PERFORMANCE IN THIN FILM RIGID DISK<br>APPLICATION'<br>* page 2629, left column, paragraph 1 *<br>* page 3630, left column, Disk Manufacturing<br>Process *<br>----- | 1-5 | |
| | | | **TECHNICAL FIELDS SEARCHED (Int. Cl.5 )**<br><br>G11B |

The present search report has been drawn up for all claims

| Place of search | Date of completion of the search | Examiner |
|---|---|---|
| THE HAGUE | 17 DECEMBER 1991 | KLOCKE S. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P0401)